# FASCICULE DE BREVET EUROPEEN

(11) **EP 0 852 814 B1**
(45) Date de publication et mention de la délivrance du brevet: **25.09.2002**
(21) Numéro de dépôt: 97929353.7
(22) Date de dépôt: 13.06.1997
(51) Int. Cl.: H01L 29/786, H01L 29/08, H01L 29/06, H01L 21/336

(54) **TRANSISTOR MOS A PUITS QUANTIQUE ET PROCEDES DE FABRICATION DE CELUI-CI**
QUANTENTOPF-MOS-TRANSISTOR UND VERFAHREN ZUR HERSTELLUNG
QUANTUM WELL MOS TRANSISTOR AND METHODS FOR MAKING SAME

(30) Priorité: 14.06.1996 FR 9607444
(43) Date de publication de la demande: 15.07.1998
(73) Titulaire: COMMISSARIAT A L'ENERGIE ATOMIQUE, 75015 Paris Cédex 15 (FR)
(72) Inventeur: DELEONIBUS, Simon, F-38640 Claix (FR)
(74) Mandataire: Des Termes, Monique
(86) Numéro de dépôt international: FR9701075
(87) Numéro de publication internationale: WO97048135

(56) Documents cités:
- US-A- 5 043 778
- US-A- 5 132 755
- US-A- 5 336 904
- PATENT ABSTRACTS OF JAPAN vol. 018, no. 359 (E-1574), 6 Juillet 1994 & JP 06 097435 A (HITACHI LTD), 8 Avril 1994,
- IBM TECHNICAL DISCLOSURE BULLETIN, vol. 17, no. 4, Septembre 1974, NEW YORK, US, pages 1075-1076, XP002025078 ANONYMOUS: "Tunnel Transistor. September 1974."
- PATENT ABSTRACTS OF JAPAN vol. 011, no. 017 (E-471), 17 Janvier 1987 & JP 61 188969 A (MATSUSHITA ELECTRIC IND CO LTD), 22 Août 1986,
- PATENT ABSTRACTS OF JAPAN vol. 007, no. 140 (E-182), 18 Juin 1983 & JP 58 054668 A (FUJITSU KK), 31 Mars 1983,
- PATENT ABSTRACTS OF JAPAN vol. 005, no. 103 (E-064), 3 Juillet 1981 & JP 56 046557 A (CHIYOU LSI GIJUTSU KENKYU KUMIAI), 27 Avril 1981,
- PATENT ABSTRACTS OF JAPAN vol. 011, no. 400 (E-569), 26 Décembre 1987 & JP 62 160769 A (HITACHI LTD), 16 Juillet 1987,
- PATENT ABSTRACTS OF JAPAN vol. 011, no. 390 (E-567), 19 Décembre 1987 & JP 62 154668 A (TOSHIBA CORP), 9 Juillet 1987,
- PATENT ABSTRACTS OF JAPAN vol. 010, no. 228 (E-426), 8 Août 1986 & JP 61 063057 A (NIPPON TELEGR & TELEPH CORP), 1 Avril 1986,

## Description

### DOMAINE TECHNIQUE

La présente invention concerne un transistor MOS (Métal-Oxyde-Semiconducteur) à puits quantique et des procédés de fabrication de celui-ci.

Elle trouve des applications en microélectronique pour la fabrication de divers dispositifs comme par exemple les inverseurs numériques qui utilisent des transistors MOS complémentaires l'un de l'autre.

### ÉTAT DE LA TECHNIQUE ANTÉRIEURE

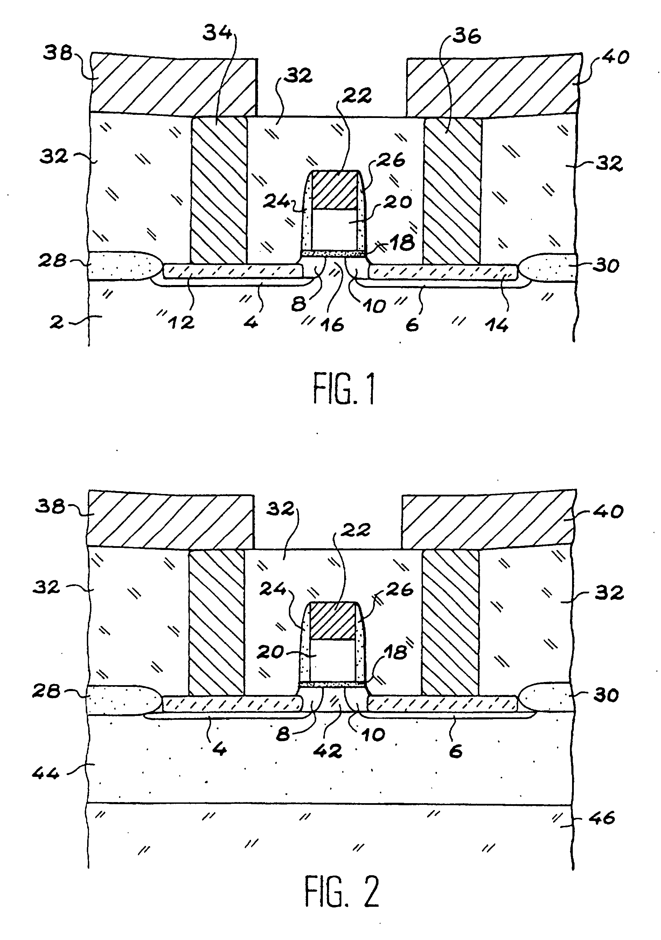

La figure 1 est une vue en coupe transversale schématique d'un transistor MOS classique, à la fin du procédé d'intégration de ce transistor.

Le transistor de la figure 1 comprend un substrat 2 en silicium de type p.

Sur ce substrat 2 sont formés deux zones 4 et 6 espacées l'une de l'autre.

Ces zones 4 et 6 sont des zones diffusées de type n⁺ formant la source et le drain du transistor.

Comme on le voit sur la figure 1, les zones 4 et 6 sont respectivement prolongées par des zones 8 et 10 qui sont des zones diffusées de type n⁻ (moins dopées que les zones 4 et 6).

Les zones 8 et 10 constituent des extensions des zones de source et de drain sous la grille du transistor dont il sera question par la suite.

Le transistor de la figure 1 comprend aussi deux zones 12 et 14 qui s'étendent respectivement au-dessus des zones 4 et 6 et sensiblement au même niveau que les zones 8 et 10 (qui sont en face l'une de l'autre et seulement séparées l'une de l'autre par un faible intervalle de silicium de type p).

Ces zones 12 et 14 sont faites d'un siliciure métallique et sont auto-alignées par rapport à la grille du transistor et par rapport aux zones d'isolation de champ de ce transistor, dont il sera question par la suite.

Les zones 12 et 14 constituent les métallisations-shunts de la source et du drain du transistor.

Au-dessus de la zone 16 en silicium de type p qui sépare les zones 8 et 10 l'une de l'autre, se trouve une couche électriquement isolante 18 en silice qui s'étend également au-dessus de ces zones 8 et 10 et qui constitue l'isolant de grille du transistor.

Au-dessus de la couche 18 se trouve une couche 20 de silicium polycristallin.

Au-dessus de cette couche 20 se trouve une couche 22 qui est faite d'un siliciure métallique et constitue une métallisation-shunt.

La grille du transistor est formée par ces couches 20 et 22.

De plus, deux espaceurs électriquement isolants 24 et 26, par exemple en silice ou en nitrure de silicium, s'étendent de part et d'autre de l'empilement constitué par les couches 20 et 22, jusqu'à l'isolant de grille 18.

Le transistor représenté sur la figure 1 est électriquement isolé d'autres transistors identiques (non représentés), également formés sur le substrat 2, grâce à des zones d'isolation de champ 28 et 30 de type LOCOS.

L'ensemble de la structure ainsi obtenue est recouvert par une couche 32 isolante, en verre de silice dopé au phosphore et au bore.

Deux ouvertures traversent de part en part cette couche 32 et débouchent respectivement sur les zones 12 et 14.

Ces deux ouvertures sont remplies d'un métal par dépôt chimique en phase vapeur et constituent respectivement des contacts de source et de drain 34 et 36.

Le transistor de la figure 1 comprend aussi deux couches métalliques d'interconnexion 38 et 40 qui se trouvent à la surface de la couche 32 et prolongent respectivement les contacts 34 et 36.

Le contact de grille n'est pas représenté sur la figure 1.

La figure 2 est une vue en coupe transversale schématique d'un autre transistor MOS classique.

Il s'agit d'un transistor MOS sur SOI (silicium sur isolant) qui est représenté à la fin de son procédé d'intégration.

Le transistor de la figure 2 diffère de celui de la figure 1 par le fait que les couches 4 et 6 y sont beaucoup plus minces et que ces couches 4, 6 et la zone 42 en silicium, comprise entre ces dernières, reposent sur une couche épaisse 44 de silice enterrée qui repose elle-même sur un substrat de silicium 46.

On connaît également un transistor MOS à puits quantique par le document suivant auquel on se reportera :
(1) Silicon single hole quantum dot transistor for complementary digital circuits, E. Leobandung, L. Guo et S.Y. Chou, IEDM 95, p.367 à 370.

Dans ce transistor connu par le document (1), la grille est rapportée après la réalisation des zones de source et de drain.

La taille de ce transistor connu est telle que son comportement électrique n'est pas complètement lié au comportement du puits quantique que comprend ce transistor.

En fait, ce transistor connu comporte, entre la source et le drain du transistor, un canal de faibles dimensions, mais la grille rapportée sur la source et le drain a, proportionnellement, une taille importante.

Ceci constitue un inconvénient pour l'augmentation du taux d'intégration de transistors de ce type.

### EXPOSÉ DE L'INVENTION

La présente invention a pour objet un transistor MOS à puits quantique ainsi que des procédés de fabrication de ce transistor, qui permettent de remédier à l'inconvénient précédent.

Ces procédés permettent d'aligner les zones de source et de drain du transistor sur la grille de celui-ci par gravure sélective.

Patent Abstracts of Japan vol.018, n° 359 (E-1574), 6 juillet 1994 et JP 06 097435A (Hitachi Ltd), 8 avril 1994, décrit un dispositif semiconducteur de type MOS. Un film d'oxyde qui est si mince qu'un courant tunnel s'écoule directement, est formé entre une région de source et une région de drain et un substrat en silicium.

IBM Technical Disclosure Bulletin, vol. 17, n° 4, septembre 1974, NEW YORK, US, pages 1075-1076, XP002025078 Anonymous : Tunnel Transistors. September 1974 décrit un transistor à effet de champ dans lequel la source et le drain sont délimités par une couche isolante, permettant l'effet tunnel.

US-A-5336904 (Kusunoki Shigeru) 9 août 1994 décrit un transistpr à effet de champ utilisant un substrat en silicium monocristallin.

Au moins deux couches minces indépendantes de silicium amorphe sont prévues pour empêcher les mouvements de porteurs majoritaires dans la région du canal à la surface du substrat de silicium.

Patent Abstracts of Japan vol. 005, n° 103 (E-064), 3 juillet 1981 et JP 56 046557A (Chiyou LSI Gijutsu Kenkyu Kumiai), 27 avril 1981, décrit la fabrication d'un transistor à effet de champ qui a de petites dimensions et des caractéristiques stables.

De façon précise, la présente invention a tout d'abord pour objet un transistor de type MOS comprenant :
- un substrat semiconducteur,
- une zone de grille,
- un canal semiconducteur placé sous la zone de grille et électriquement isolé de celle-ci, et
- une zone de source et une zone de drain qui sont placées de part et d'autre de la zone de grille et du canal et qui sont électriquement isolées du substrat et de la zone de grille,
les zones de source et de drain étant séparées du canal respectivement par des couches électriquement isolantes qui sont suffisamment minces pour permettre le passage de porteurs de charges, par effet tunnel, de la zone de source à la zone de drain à travers le canal; ce transistor étant caractérisé en ce que chacune des zones de source et de drain est séparée du substrat par une couche électriquement isolante dont l'épaisseur est suffisamment forte pour empêcher tout passage de porteurs de charges à travers cette couche isolante.

De préférence, chacune des zones de source et de drain est faite d'un matériau métallique, ce qui permet de minimiser les résistances électriques d'accès du transistor.

Ces résistances d'accès sont également minimisées par le fait qu'une partie de la zone de source et une partie de la zone de drain se trouvent sous la zone de grille du transistor.

Selon un premier mode de réalisation particulier du transistor objet de l'invention, le canal est électriquement isolé du substrat.

Selon un deuxième mode de réalisacion particulier, le canal est en contact en électrique avec le substrat par l'intermédiaire d'une étroite zone de ce substrat.

Selon un mode de réalisation préféré du transistor objet de l'invention, le substrat et le canal sont en silicium.

Dans ce cas, les couches isolantes suffisamment minces peuvent être en silice ou en nitrure de silicium.

La couche isolante qui sépare chacune des zones de source et de drain peut être une couche de silice, le transistor ayant ainsi une structure d'un type que l'on peut appeler pseudo-SOI.

Dans un mode particulier de réalisation de l'invention, la zone de source, la zone de drain et le canal sont séparés du substrat par une couche électriquement isolante très épaisse, qui peut être en silice, le transistor ayant ainsi une structure de type SOI (silicium sur isolant).

La présente invention a également pour objet un procédé de fabrication du transistor objet de l'invention comme défini dans la revendication 10.

Par "zone active", on entend la zone où seront formés la source, le drain et la région du canal située sous la grille.

Selon un premier mode de mise en oeuvre particulier de ce procédé lorsque le substrat est en silicium et les couches d'épaisseur suffisamment forte en silice, lesdites couches isolantes suffisamment minces sont d'abord formées et lesdites couches de silice sont ensuite formées en dopant des zones du substrat au fond des évidements, par des impuretés permettant une oxydation rapide du substrat, puis en oxydant les zones ainsi dopées.

Dans ce cas, les couches isolantes suffisamment minces peuvent être en silice ou en nitrure de silicium.

Selon un deuxième mode de mise en oeuvre particulier de ce procédé lorsque le substrat est en silicium et les couches d'épaisseur suffisamment forte en silice, pour former lesdites couches isolantes suffisamment minces et lesdites couches de silice, on dépose du nitrure de silicium dans les évidements, on élimine le nitrure ainsi déposé, l'élimination n'ayant pas lieu sur les flancs de manière à former lesdites couches isolantes suffisamment minces, et on oxyde des zones du substrat au fond des évidements de manière à former lesdites couches de silice.

En variante lorsque le substrat est en silicium et les couches d'épaisseur suffisamment forte en silice, pour former lesdites couches isolantes suffisamment minces et lesdites couches de silice, on peut déposer du nitrure de silicium dans les évidements, éliminer le nitrure ainsi déposé, l'élimination n'ayant pas lieu sur lesdits flancs, puis oxyder des zones de substrat au fond des évidements de manière à former lesdites couches de silice, puis éliminer le nitrure desdits flancs et oxyder ces flancs de manière à former lesdites couches isolantes suffisamment minces.

La présente invention a aussi pour objet un autre procédé de fabrication du transistor objet de l'invention, comprenant ladite couche très épaisse, cet autre procédé étant défini par la revendication 15.

Dans ce cas, on peut utiliser un substrat en silicium et une couche très épaisse en silice et lesdites couches isolantes suffisamment minces peuvent encore être en silice ou en nitrure de silicium.

Dans ce cas également, on peut utiliser un substrat en silicium et une couche très épaisse en silice et pour former lesdites couches isolantes suffisamment minces on peut déposer du nitrure de silicium dans les évidements et éliminer le nitrure ainsi déposé, l'élimination n'ayant pas lieu sur lesdits flancs.

Comme on le verra mieux par la suite, dans la présente invention, lorsque le canal du transistor ayant une structure de type pseudo-SOI a une faible longueur, l'isolant au-dessus duquel se trouve la zone de source et l'isolant au-dessus duquel se trouve la zone de drain peuvent se rejoindre.

Ceci délimite alors un volume confiné de silicium qui peut jouer le rôle de puits quantique.

Le transistor est alors capable de fonctionner en régime quantique.

Dans un transistor fonctionnant en régime classique (non quantique), le transport des porteurs de charge a lieu dans une couche d'inversion à l'interface entre l'isolant de grille et le substrat du transistor.

Dans cette couche d'inversion, il existe un continuum d'états permis.

Dans un transistor conforme à l'invention fonctionnant en régime quantique, on obtient une couche d'inversion présentant des états permis discontinus.

On précise qu'un transistor fonctionne en régime quantique quand la différence d'énergie entre deux niveaux permis est à peu près égale à l'énergie d'agitation thermique des électrons ou supérieure à cette énergie d'agitation thermique.

Pour un puits quantique, la partie active est de très faible taille par rapport au libre parcours moyen d'un électron.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1, déjà décrite, est une vue en coupe transversale schématique d'un transistor MOS connu, formé sur un substrat semiconducteur massif,
- la figure 2, déjà décrite, est une vue en coupe transversale schématique d'un autre transistor MOS connu, ayant une structure de type SOI,
- les figures 3 à 9 illustrent schématiquement diverses étapes d'un procédé conforme à l'invention, permettant d'obtenir un transistor à structure de type pseudo-SOI,
- les figures 10 à 14 illustrent schématiquement des étapes d'un autre procédé conforme à l'invention, permettant d'obtenir un transistor à structure de type SOI,
- les figures 15 à 22 illustrent schématiquement des étapes de variantes du procédé illustré par les figures 3 à 9, permettant aussi d'obtenir un transistor conforme à l'invention, à structure de type pseudo-SOI, et
- la figure 23 illustre schématiquement une étape d'une variante du procédé illustré par les figures 10 à 14, permettant aussi d'obtenir un transistor conforme à l'invention, à structure de type SOI.

### EXPOSÉ DÉTAILLÉ DE MODES DE RÉALISATION PARTICULIERS

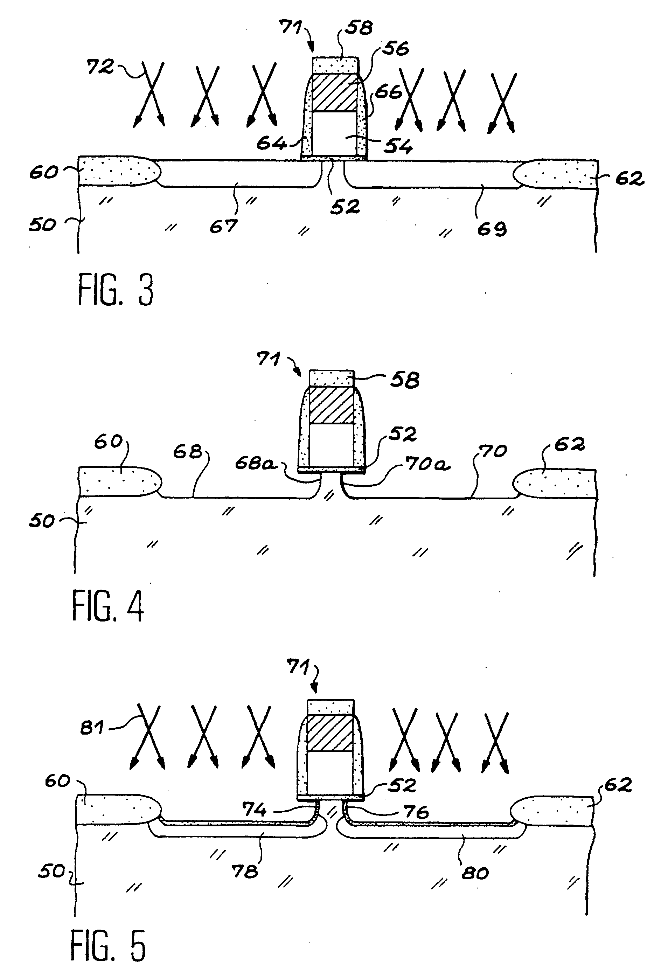

Les transistors MOS conformes à l'invention, dont la fabrication est expliquée en faisant référence aux figures 3 à 23, ont une longueur qui peut aller de quelques nanomètres à plusieurs micromètres.

En atteignant des longueurs de quelques nanomètres, le fonctionnement de tels transistors MOS est altéré par la possibilité d'un transfert direct de la source jusqu'au drain (effet balistique) ainsi que par les fluctuations de dopage dans le canal.

Ces deux phénomènes sont d'autant plus critiques que le nombre de porteurs de charges impliqués est faible.

La présente invention permet :
- de maîtriser les effets balistiques par utilisation de structures de type MIS (métal-isolant-semiconducteur) utilisant un effet tunnel, et
- de réaliser un puits quantique entre la source et le drain d'un transistor MOS, permettant un blocage coulombien des porteurs de charges, assurant ainsi un fonctionnement quasiment mono-porteur ou complètement mono-porteur de très haute performance pour ce transistor.

De plus, dans le cas des figures 3 à 9, l'invention, appliquée à l'obtention de transistors MOS à structure de type pseudo-SOI, permet :
- de réduire quasiment à zéro les fuites de jonction, d'assurer une forte isolation et de réduire fortement la distance "n⁺/p⁺" comme dans le cas de dispositifs de type SOI, et
- de réduire fortement les capacités des diodes de drain/substrat.

On a ainsi les avantages des dispositifs de type SOI pour des transistors réalisés à partir d'un substrat en silicium massif.

De plus, les transistors obtenus sont susceptibles d'avoir de très faibles dimensions permettant de réaliser un blocage coulombien pour des dispositifs micro-électroniques contenant ces transistors.

Les étapes d'un procédé conforme à l'invention, qui sont schématiquement illustrées par les figures 3 à 9 permettent d'obtenir un transistor MOS qui est à comparer au transistor de la figure 1.

Pour mettre en oeuvre ce procédé, on commence par former, de façon connue, une structure comprenant un substrat massif 50 en silicium monocristallin de type p (figure 3).

Cette structure comprend aussi :
- une couche isolante 52 en silice, ou couche d'oxyde de grille, qui est en contact avec le substrat 50,
- une couche 54 en silicium polycristallin qui repose sur la couche 52,
- une métallisation-shunt 56 qui repose sur la couche 54, et
- une couche isolante 58, par exemple en nitrure de silicium, qui repose sur la métallisation-shunt 56.

La grille est constituée par les couches 54 et 56.

La structure comprend aussi deux zones d'isolation de champ 60 et 62 qui sont placées de part et d'autre de l'ensemble de couches 52 à 58 et sont réalisées avant cette dernière, par exemple par la méthode appelée LOCOS.

Sur cette structure, on commence par graver des espaceurs 64 et 66 de façon que ces espaceurs reposent sur la couche 52 et encadrent les couches 54 et 56, comme on le voit sur la figure 3.

L'ensemble 71 constitué par les couches 52 à 58 et les espaceurs 64 et 66 peut être appelé "zone de grille".

On forme ensuite deux évidements 68 et 70 dans le substrat 50 (figure 4).

L'évidement 68 est compris entre la zone 60 et la zone de grille et l'évidement 70 est compris entre la zone 62 et cette zone de grille.

Ces évidements 68 et 70 s'étendent sous la couche 52 comme on le voit sur la figure 4.

Pour obtenir ces évidements 68 et 70, on peut procéder à une gravure du silicium isotrope et sélective par rapport à la grille et à l'isolation de champ, pendant un temps approprié.

Cependant, pour mieux maîtriser géométriquement la structure finalement obtenue, représentée sur la figure 4, il est préférable, pour obtenir les évidements 68 et 70, de commencer par réaliser une implantation p⁺ dans des zones 67 et 69 (figure 3) du substrat, ces zones correspondant aux évidements 68 et 70 que l'on veut obtenir.

Pour ce faire, on utilise un faisceau 72 d'ions bore à forte dose, de manière à obtenir une concentration finale moyenne de 10¹⁹ à 10²⁰ atomes par cm³.

Pour s'affranchir des effets d'ombrage dus à la zone de grille, on réalise une implantation avec inclinaison et rotation du substrat.

Un recuit d'implantation, suivi par une diffusion, permet d'ajuster la longueur finale du canal du transistor que l'on veut réaliser.

On élimine également l'oxyde résiduel de source et de drain ; en effet, quand on forme la couche 52, de la silice se dépose partout entre les zones 60 et 62 et cette silice est partiellement éliminée lors de la gravure de la zone de grille et des espaceurs 64 et 66 ; l'implantation est réalisée à travers la couche de silice résiduelle, puis le recuit a lieu et l'on élimine ensuite cette couche comme on l'a indiqué ci-dessus.

On effectue ensuite une gravure sélective du silicium p⁺ (zones 67 et 69) par rapport au silicium de type p du substrat (où il n'y a pas eu d'implantation).

Pour ce faire, on utilise un mélange du type HF, HNO₃, CH₃COOH qui est décrit dans le document suivant, auquel on se reportera :
(2) Extremely high selective etching of porous Si for single etch-stop bond-and-etch-back SOI, K. Sakaguchi, N. Sato, K. Yamagata, Y. Fujiyama et T. Yonehara, Extended abstracts of the 1994 International conference on solid state devices and materials, Yokohama, 1994, p. 259 à 261.

Ce mélange attaque le silicium dopé p⁺ avec une sélectivité égale à 100 par rapport au silicium de type p.

On réalise ensuite une nitruration rapide du silicium exposé, au moyen de gaz ammoniac par exemple, ce qui conduit à l'obtention de couches très minces 74 et 76 (figure 5) en nitrure de silicium sur les flancs 68a et 70a des évidements 68 et 70, flancs qui se trouvent sous la couche 52, ainsi qu'au fond des évidements.

Au lieu d'effectuer cette nitruration rapide, on peut effectuer une oxydation rapide du silicium, ce qui conduit alors à des couches 74 et 76 en silice.

On procède ensuite à une implantation à forte dose, de type n⁺, du substrat, au fond des évidements 68 et 70 à travers les couches 74 et 76 du fond des évidements.

La couche de nitrure est détruite par l'implantation n⁺ à cause de la forte dose, sauf aux endroits protégés par l'ombrage dû à la présence de la grille.

Les zones à dopage n⁺ qui résultent de cette implantation au fond des évidements ont les références 78 et 80 sur la figure 5.

On utilise pour ce faire un faisceau 81 d'ions arsenic ou phosphore par exemple.

La dose est choisie pour que ces zones 78 et 80 aient un dopage de l'ordre de 10¹⁹ à 10²⁰ atomes par cm³.

De plus, l'implantation est réalisée avec le substrat incliné, ce qui permet un dopage sélectif sous la couche 52 à la profondeur souhaitée.

De plus, une rotation du substrat pendant l'implantation permet de d'affranchir de l'ombrage lié à la hauteur de la zone active de grille.

Après l'activation des dopants, on procède à une oxydation des zones implantées 78 et 80.

Les couches de silice qui résultent de cette oxydation ont respectivement les références 84 et 86 sur la figure 6.

Il est à noter que cette oxydation conduit à une formation rapide de ces couches 84 et 86.

On précise que l'oxydation à lieu jusqu'à consommation totale des zones implantées n⁺.

On précise également que l'épaisseur des couches 84 et 86 est choisie suffisamment forte pour empêcher tout effet tunnel à travers ces couches 84 et 86.

Sur les flancs déjà mentionnés des évidements, les parties des couches très minces 74 et 76 sont alors naturellement transformées en couches isolantes de formule SlOₓN_{y} qui ont les références 88 et 90 sur la figure 6.

Cette transformation naturelle est due à l'oxydation sélective du silicium dopé n⁺.

Il est à noter que les couches 88 et 90 ont une très faible épaisseur, inférieure à 2,5 nm, permettant un effet tunnel.

On peut ajuster l'épaisseur des couches 84 et 86 grâce au dopage n+ et aux conditions d'oxydation. Par exemple, si le dopage n+ est de 10E19 à 10E20/cm3, une épaisseur minimale de 8 nm sera obtenue par oxydation sous vapeur d'eau à 850°C alors que l'épaisseur des couches 88 et 90 est de 2,5 nm.

Il s'agit bien entendu là de valeurs numériques correspondant aux exemples de matériaux considérés. D'une manière générale l'effet tunnel relatif à une couche d'un matériau est fonction de la hauteur de barrière de ce matériau et de l'épaisseur de la couche. La hauteur de barrière est connue de l'homme du métier qui est donc capable de déterminer une épaisseur de la couche permettant l'effet tunnel à travers celle-ci (cas des couches 88 et 90) ou au contraire une épaisseur empêchant tout effet tunnel à travers celle-ci (cas des couches 84 et 86).

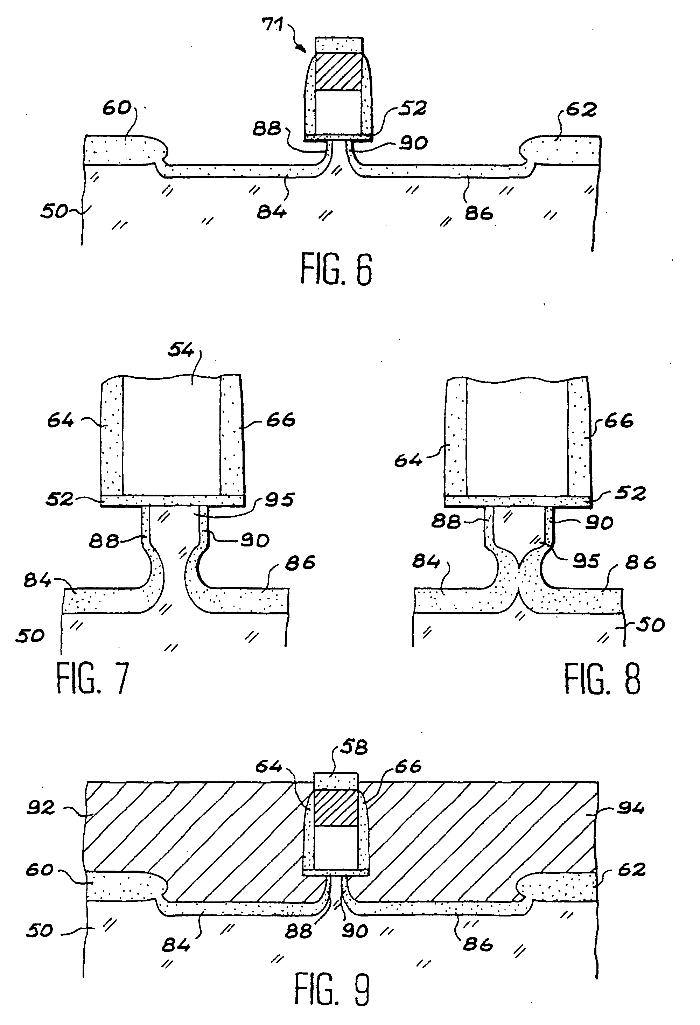

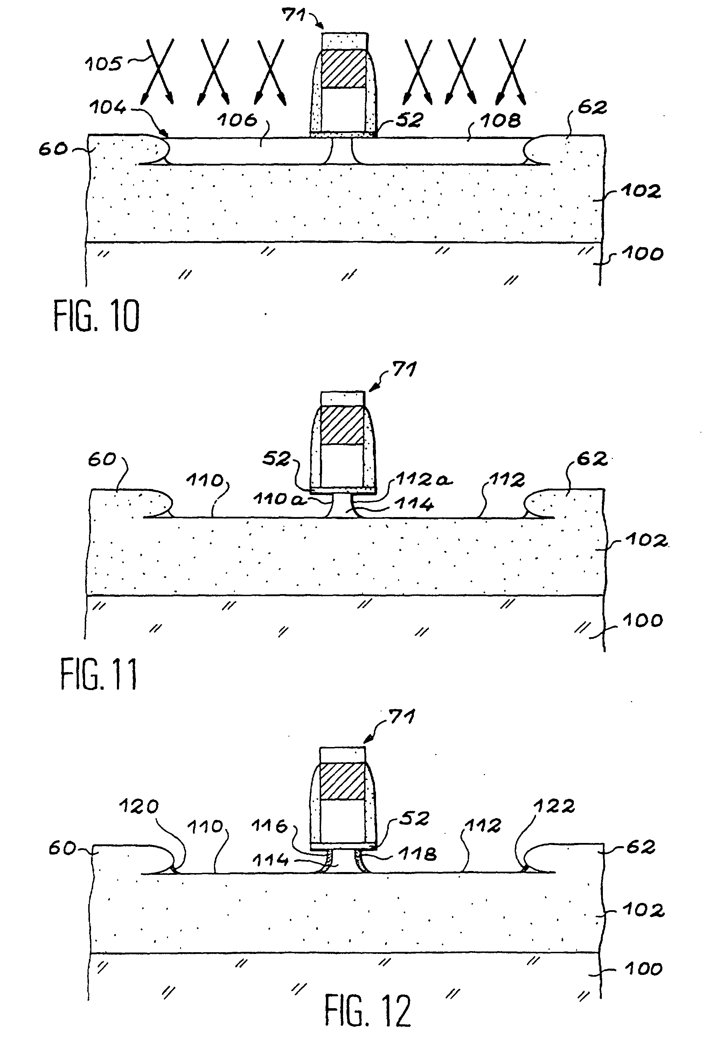

Les figures 7 et 8 montrent deux exemples des résultats obtenus sur des structures "minimales", en jouant sur l'angle d'inclinaison du faisceau d'implantation n⁺, la dose, l'énergie d'implantation, le temps d'oxydation et la taille de la grille.

On peut ensuite procéder, à travers l'isolant, à une implantation de dopant de type p sur les flancs de la grille pour compenser le dopage de type n qui est obtenu par diffusion de l'implantation n⁺.

On forme ensuite les zones de source et de drain 92 et 94 (figure 9) de part et d'autre de la zone de grille.

Pour ce faire, on dépose de préférence un matériau métallique sur la structure obtenue à la figure 6, par exemple par dépôt chimique en phase vapeur (CVD), ce matériau métallique ayant un potentiel d'extraction qui place le niveau de Fermi de ce matériau métallique vers le milieu de la bande interdite du silicium.

Ceci évite d'avoir à utiliser deux matériaux métalliques différents pour la mise en oeuvre de l'invention, à savoir :
- un matériau métallique pour l'obtention d'un transistor à canal n, ce qui correspond au cas décrit en faisant référence aux figures 3 à 9, et
- un autre matériau métallique pour l'obtention d'un transistor à canal p, ce qui nécessite l'utilisation d'un substrat 50 en silicium de type n.

Le matériau métallique ainsi déposé dépasse le niveau de la couche isolante 58 en Si₃N₄.

Ce matériau métallique est ensuite poli, cette couche 58 servant de couche d'arrêt de polissage.

On obtient ainsi des zones de source et de drain 92 et 94 dépourvues de contacts.

Les matériaux métalliques qui représentent le meilleur compromis tant du point de vue électronique que du point de vue technologique pour la réalisation des zones de source et de drain sont le tungstène, le nitrure de titane et le titane.

Dans un mode de mise en oeuvre non illustré, on réalise des diodes Schottky en utilisant par exemple du platine, de l'or ou du palladium du côté n et du titane ou de l'aluminium du côté p.

On obtient ainsi un transistor de type MOS incluant une structure de type métal-isolant-semiconducteur lorsqu'on va de la source au canal du transistor ou du drain à ce canal, l'isolant de cette structure autorisant un effet tunnel.

La région du canal n'est accessible que par franchissement de la barrière-tunnel par les porteurs de charges fournis par la source du transistor.

En revenant aux figures 7 et 8, le canal 95 du transistor peut être un volume légèrement ouvert sur le substrat (figure 7) ou un volume fermé si ce canal a une faible longueur, ne dépassant pas 10 nm environ (figure 8).

Dans le cas de la figure 7, il est possible d'évacuer les courants parasites de substrat et d'obtenir une structure de type SOI sous les zones de source et de drain à volume faiblement déplété.

Dans le cas de la figure 8, on peut considérer la structure obtenue comme un transistor de type MOS sur SOI fortement dépiété.

Il est à noter que, dans le cas de la figure 7, le canal du transistor peut être polarisé par l'intermédiaire du substrat.

La commande de la tension de blocage par le substrat se fait comme dans un transistor MOS classique.

On précise que, dans le cas de la figure 7, la longueur du canal est supérieure à environ 10 nm.

Dans le cas de la figure 8, on obtient un puits quantique dans la région du canal du transistor.

Ce puits quantique permet un piégeage coulombien des porteurs de charges par confinement.

On est ainsi capable de fabriquer, dans des structures de petite taille, des transistors MOS à mono-porteur (mono-électron ou mono-trou).

On décrit maintenant un autre procédé conforme à l'invention, permettant d'obtenir un transistor MOS dont la structure est de type SOI, en faisant référence aux figures 10 à 14.

La structure de ce transistor conforme à l'invention est à comparer à la structure du transistor schématiquement représenté sur la figure 2 déjà décrite.

Cet autre procédé de fabrication est identique au procédé conforme à l'invention, permettant d'obtenir un transistor MOS sur un substrat semiconducteur massif (figures 3 à 9) excepté en ce qui concerne la réalisation de l'isolation de la source et du drain qui n'est pas nécessaire dans le cas présent.

En effet, cette isolation est réalisée de manière naturelle par l'oxyde de silicium enterré de la structure de type SOI.

Comme le montre la figure 10, on commence par fabriquer de manière connue une telle structure de type SOI, comprenant un substrat en silicium monocristallin 100 sur lequel est formée une couche très épaisse de silice 102 enterrée, elle-même surmontée d'une couche de silicium monocristallin 104, de type p dans l'exemple représenté.

L'épaisseur de la couche 102 est choisie suffisamment grande pour empêcher tout effet tunnel direct à travers cette couche 102.

Sur cette structure, on forme de façon connue la zone de grille 71 précédemment décrite en faisant référence à la figure 3.

On forme également, comme on l'a vu plus haut, les zones d'isolation de champ 60 et 62 de part et d'autre de la zone de grille 71 par exemple par la méthode LOCOS.

On forme ensuite (figure 11) des évidements 110 et 112 dans la couche 104 ces évidements s'étendant jusqu'à la couche 102.

L'évidement 110 est compris entre la zone 60 et la zone de grille 71 et l'évidement 112 est compris entre cette dernière et la zone 62.

Entre ces deux évidements 110 et 112, il subsiste une zone 114 de silicium monocristallin destiné à contenir le canal du transistor que l'on fabrique.

Comme précédemment, les évidements peuvent être formés par gravure isotrope du silicium.

Ils peuvent aussi être formés en faisant d'abord une implantation p⁺ dans les zones 106 et 108 de la couche de silicium 104 (ces zones étant les homologues des zones 67 et 69 de la figure 3),au moyen d'un faisceau 105 d'ions appropriés, le substrat étant incliné et mis en rotation pendant cette implantation, comme on l'a vu plus haut.

Un recuit d'implantation est ensuite effectué, après quoi on élimine l'oxyde résiduel de source et de drain.

Ensuite on réalise une gravure sélective des zones de silicium dopées p⁺.

Comme le montre la figure 12, on forme ensuite sur les flancs 110a et 112a des évidements 110 et 112, flancs qui sont situés sous la couche 52 d'oxyde de grille, des couches très minces 116 et 118, d'une épaisseur de l'ordre de 1 nm par exemple.

Ces couches peuvent être en nitrure de silicium et sont alors formées par nitruration thermique rapide de la zone de silicium 14.

Elles peuvent également être en silice et sont alors formées par oxydation rapide de la zone de silicium 114.

Ces couches très minces 116 et 118 sont les homologues des parties des couches 74 et 76 de la figure 5 restant sur les flancs des évidements.

On voit également sur la figure 12 des couches de très faibles dimensions 120 et 122 qui sont formées dans le silicium, respectivement du côté des zones d'isolation de champ 60 et 62.

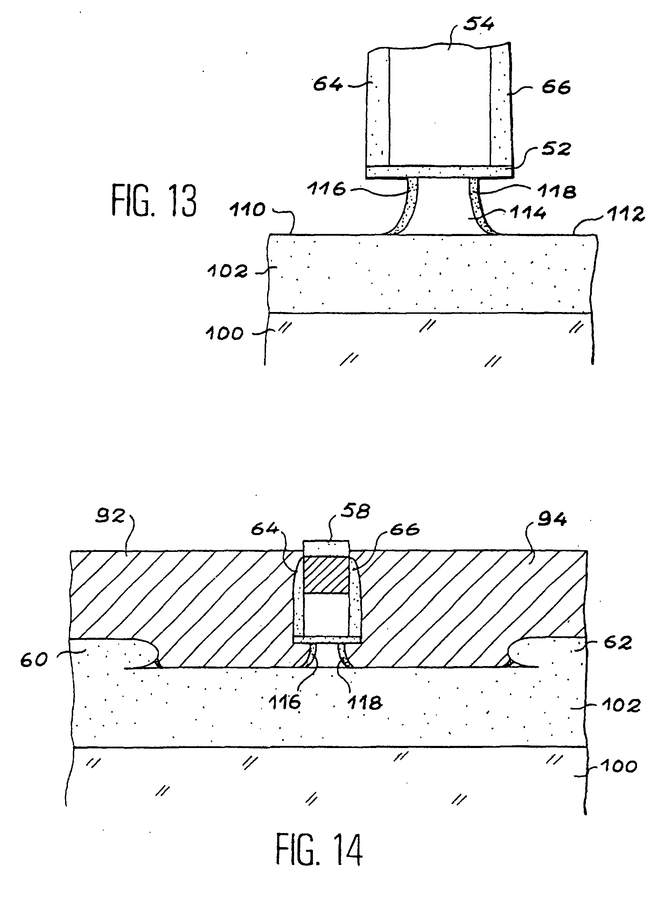

La figure 13 est une vue agrandie de la zone de canal 114 du transistor que l'on est en train de former.

Cette zone de canal 114 est séparée des évidements 110 et 112, qui sont prévus pour recevoir les zone de source et de drain, par les couches isolantes très minces 116 et 118.

Cette zone de canal 114 constitue un volume inaccessible (du point de vue électrique) depuis le substrat 100.

Cette zone de canal 114 du transistor constitue un puits quantique.

La figure 14 illustre schématiquement une autre étape permettant la formation du transistor.

Comme précédemment, cette autre étape consiste à déposer un matériau métallique, par exemple par dépôt chimique en phase vapeur, sur la structure de la figure 12, jusqu'à ce que ce matériau dépasse le niveau de la couche isolante 58.

Le matériau métallique déposé est ensuite poli, cette couche isolante 58 servant de couche d'arrêt de polissage.

On obtient ainsi les zones de source et de drain 92 et 94.

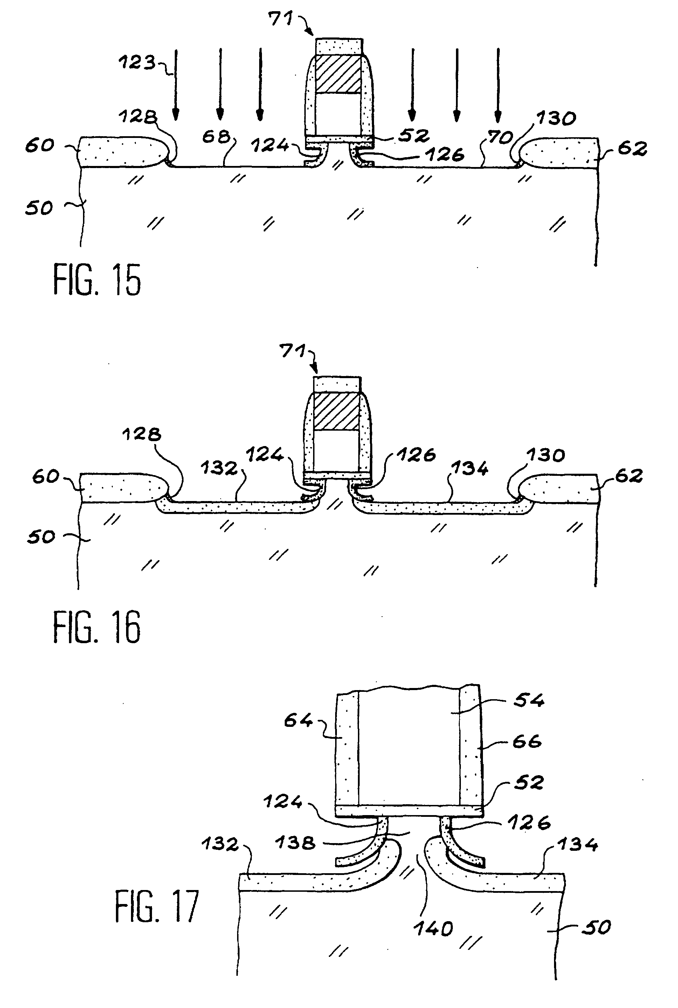

Les figures 15 à 19 illustrent schématiquement des étapes d'un autre procédé conforme à l'invention, permettant l'obtention d'un transistor MOS à structure de type pseudo-SOI.

Dans cet autre procédé, au lieu d'utiliser un effet d'oxydation différentielle d'une couche implantée n⁺ par rapport au silicium peu dopé, on utilise une oxydation localisée par dépôt et gravure d'une couche de nitrure de silicium.

Plus précisément, on forme d'abord par des étapes non représentées une structure identique à celle de l'on voit sur la figure 4.

Ensuite, comme l'illustrent schématiquement les flèches 123 de la figure 15, un mince dépôt de nitrure de silicium est formé, par exemple par dépôt chimique en phase vapeur à basse pression ("low pressure chemical vapour deposition") dans les évidements 68 et 70 de cette structure, notamment sur les flancs de ces évidements, flancs qui se trouvent sous la couche 52.

L'épaisseur de ce dépôt sur ces flancs est telle que le passage des électrons dans la partie active du transistor que l'on veut former se fasse par effet tunnel.

Cette épaisseur est par exemple de l'ordre de quelques nanomètres à 2,5 nanomètres.

Ensuite, une gravure anisotrope et sélective par rapport au silicium est réalisée de façon auto-alignée sur la grille.

On voit sur la figure 15 les couches minces et isolantes 124 et 126 permettant l'effet tunnel, qui subsistent au niveau des flancs des évidements, considérés ci-dessus.

On précise qu'on exploite encore l'ombrage de la zone de grille 71 lors du dépôt du nitrure de silicium et de la gravure de ce dernier.

On voit également sur la figure 15 des couches de très petites dimensions en nitrure de silicium 128 et 130 qui subsistent après gravure du nitrure de silicium aux extrémités des évidements respectivement situées du côté des zones d'isolation de champ 60 et 62.

On réalise ensuite une oxydation localisée du silicium au niveau du fond des évidements 68 et 70.

Les couches de silice localisée ainsi obtenues ont les références 132 et 134 sur la figure 16.

L'épaisseur de ces zones 132 et 134 est telle :
- qu'aucun effet tunnel direct n'est possible à travers ces couches 132 et 134, et
- que les couches de nitrure de silicium 124 et 126 ne soient pas consommées complètement.

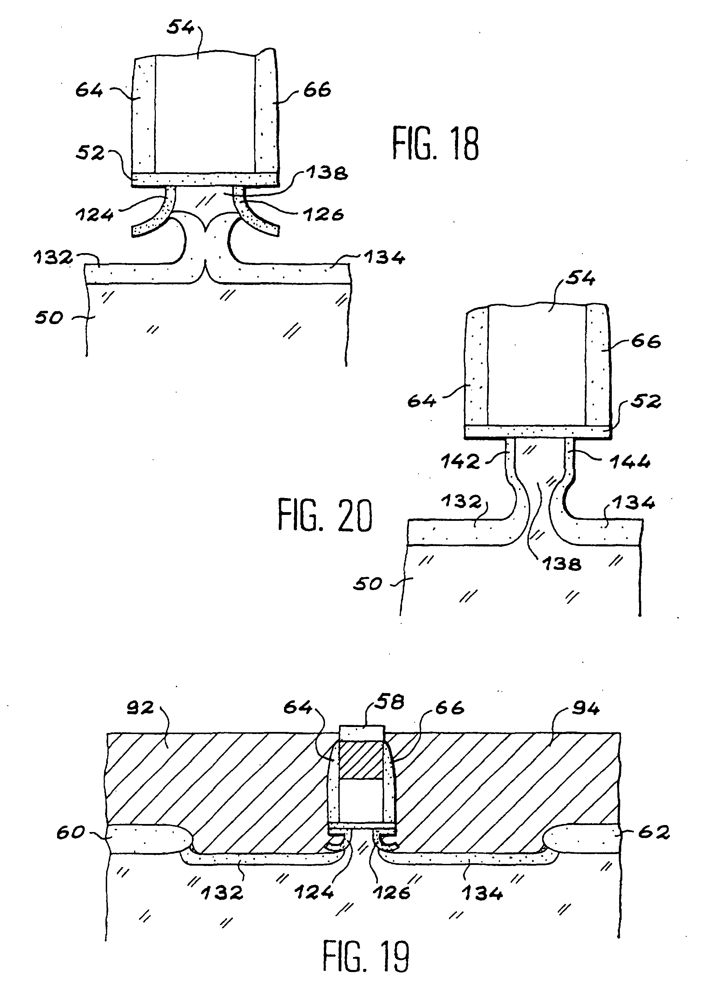

Les figures 17 et 18 (respectivement homologues des figures 7 et 8) montrent le volume de silicium monocristallin 138 destiné à contenir le canal du transistor.

Ce volume 138 est délimité par les couches très minces 124 et 128 permettant l'effet tunnel.

Dans le cas de la figure 17, ce volume communique avec le substrat 50 en silicium monocristallin par une zone très étroite de ce substrat.

Cette zone très étroite est délimitée par les extrémités des couches 132 et 134, extrémités qui se font face sous la couche 52.

Cette communication permet la formation d'un transistor MOS commandé par l'intermédiaire du substrat 50.

Dans le cas de la figure 18, le volume de silicium 138, destiné à contenir le canal du transistor, est électriquement isolé du substrat 50.

Ce volume 138 également délimité par les couches très minces 124 et 126 permet d'obtenir un puis quantique.

La figure 19 illustre schématiquement la formation des zones de source et de drain 92 et 94 du transistor.

Cette formation a lieu par dépôt d'un matériau métallique puis polissage de celui-ci jusqu'au niveau de la couche isolante 58 (qui sert de couche d'arrêt pour le polissage), comme on l'a déjà expliqué.

En variante, après la formation des couches de silice 132 et 134 (figure 16), il est possible de retirer les parties de nitrure de silicium 124, 126, 128 et 130 qui subsistent, de façon sélective par rapport à la silice et au silicium, en utilisant pour ce faire une solution d'acide de Caro.

A ce sujet, on consultera le document suivant :
(3) S. Deleonibus et al. JECP Décembre 1991, pages 3739 à 3742.

On fait ensuite une oxydation localisée et rapide du' siliciuim au niveau des flancs des évidements, considérés plus haut.

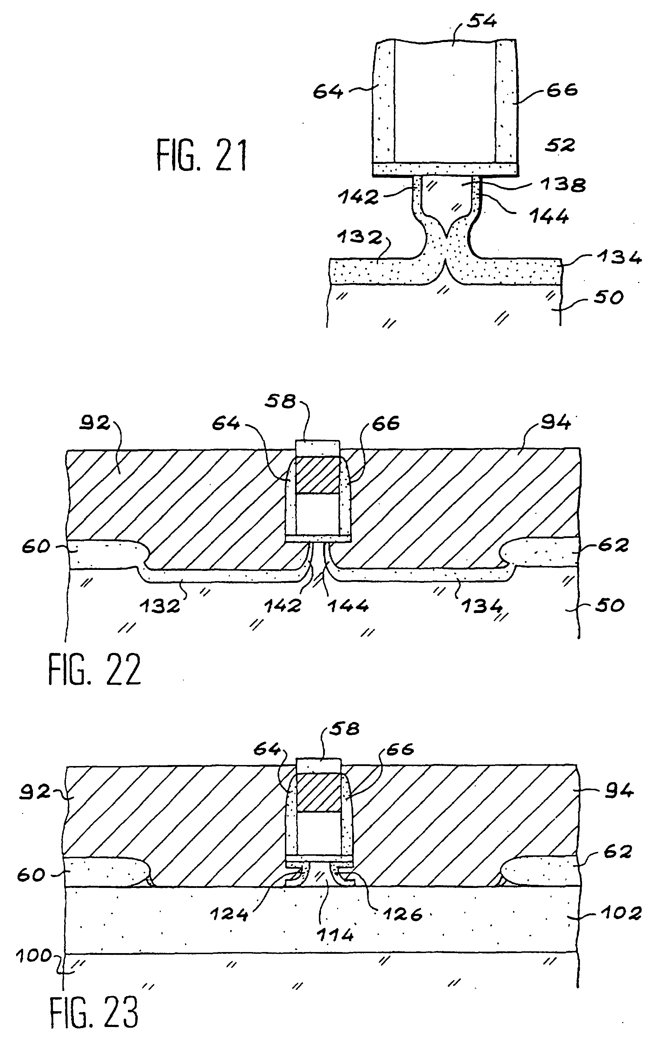

Cette variante est schématiquement illustrée par les figures 20 et 21 qui sont respectivement les homologues des figures 17 et 18.

On voit sur ces figures 20 et 21 les couches d'oxyde de silicium très minces 142 et 144 qui sont obtenues par cette oxydation sélective (et qui remplacent les couches de nitrure de silicium 124 et 126).

Ces couches très minces 142 et 144 permettent encore un effet tunnel.

On voit également sur les figures 20 et 21 le volume de silicium 138 des figures 17 et 18, qui est délimité par les couches très minces 142 et 144.

La figure 22 illustre schématiquement l'achèvement du transistor résultant du procédé correspondant aux figures 20 et 21 (dépôt du matériau métallique permettant la formation des zones de source et drain 92 et 94).

La figure 23 est une vue en coupe transversale et schématique d'un autre transistor conforme à l'invention, formé sur une structure de type SOI.

Plus précisément, ce transistor de la figure 23 est obtenu comme on l'a expliqué en faisant référence aux figures 15 à 19 ou en utilisant la variante expliquée dans la description des figures 20 et 21, excepté que l'utilisation d'une structure initiale SOI ne nécessite pas l'oxydation localisée ayant permis la formation des couches 132 et 134.

On procède donc au dépôt du matériau métallique par dépôt chimique en phase vapeur après gravure du nitrure de silicium, de façon sélective par rapport à la silice.

On voit sur la figure 23 le substrat 100 en silicium, la couche de silice 102 enterrée, la zone de canal 114 en silicium et les zones de source et drain 92 et 94 qui sont séparées de la zone de canal 114 par des couches très minces en nitrure de silicium 124 et 126.

Bien entendu, dans tous les exemples donnés, un contact de grille est ultérieurement formé pour achever le transistor.

De plus, dans ces exemples, on a utilisé du silicium de type p pour le substrat dans les structures pseudo-SOI ou, dans les structures SOI, pour la couche de silicium où l'on forme les évidements, mais l'invention englobe bien entendu les transistors et procédés de fabrication correspondants qui utilisent un silicium de type n ou tout autre semiconducteur approprié (de type n ou p).

On donne ci-après un exemple d'application particulier du transistor MOS objet de l'invention aux mémoires non volatiles.

Cette application est relative aux transistors partiellement représentés sur les figures 8 et 18, dont le canal est un volume fermé.

Les structures de type pseudo-SOI représentées sur les figures 8 et 18 peuvent être utilisées comme un point mémoire non volatile.

On peut, en injectant des électrons par la source du transistor et par application d'une polarisation positive sur le substrat 50, stocker des électrons dans la zone du substrat 95 (figure 8) ou 138 (figure 18) au niveau de la jonction des couches d'oxyde 84, 86 (figure 8) et 132, 134 (figure 18) ayant une forme en V.

Dans ce coin, la contrainte liée à la rencontre des deux fronts d'oxydation latéraux induit des états de charge qui sont susceptibles de piéger les électrons à condition qu'ils quittent le canal de conduction.

Cette dernière condition est remplie si l'on polarise positivement le substrat 50.

La zone du substrat 95 ou 138 en forme de V joue alors le rôle de capacité de stockage du point mémoire.

Son état de charge influence la tension de seuil du transistor MOS de manière électrostatique comme dans un point mémoire non volatile classique.

## Revendications

1. Transistor de type MOS comprenant :
- un substrat semiconducteur (50 ; 100),
- une zone de grille (71),
- un canal semiconducteur (95 ; 114 ; 138) placé sous la zone de grille et électriquement isolé de celle-ci, et
- une zone de source et une zone de drain (92, 94) qui sont placées de part et d'autre de la zone de grille et du canal et qui sont électriquement isolées du substrat et de la zone de grille,
les zones de source et de drain étant séparées du canal respectivement par des couches électriquement isolantes (88,90; 116, 118; 124, 126 ; 142, 144) qui sont suffisamment minces pour permettre le passage de porteurs de charges, par effet tunnel, de la zone de source à la zone de drain à travers le canal; ce transistor étant **caractérisé en ce que** chacune des zones de source et de drain est séparée du substrat par une couche électriquement isolante dont l'épaisseur est suffisamment forte pour empêcher tout passage de porteurs de charges à travers cette couche isolante.

2. Transistor de type MOS selon la revendication 1, **caractérisé en ce que** chacune des zones de source et de drain (92, 94) est faite d'un matériau métallique.

3. Transistor de type MOS selon l'une quelconque des revendications 1 et 2, **caractérisé en ce que** le canal est électriquement isolé du substrat (50; 100).

4. Transistor de type MOS selon l'une quelconque des revendications 1 et 2, **caractérisé en ce que** le canal est en contact électrique avec le substrat (50; 100)par l'intermédiaire d'une étroite zone de ce substrat, cette zone étant plus petite que le canal.

5. Transistor de type MOS selon l'une quelconque des revendications 1 à 4, **caractérisé en ce que** le substrat (50; 100) et le canal (95; 114; 138) sont en silicium.

6. Transistor de type MOS selon la revendication 5, **caractérisé en ce que** les couches isolantes suffisamment minces sont en silice.

7. Transistor de type MOS selon la revendication 5, **caractérisé en ce que** les couches isolantes suffisamment minces sont en nitrure de silicium.

8. Transistor de type MOS selon l'une quelconque des revendications 5 à 7, **caractérisé en ce que** la couche isolante qui sépare chacune des zones de source et de drain (92, 94) du substrat est une couche de silice (84; 86; 132, 134).

9. Transistor de type MOS selon l'une quelconque des revendications 1 à 7, **caractérisé en ce que** la zone de source, la zone de drain et le canal sont séparés du substrat par une couche électriquement isolante très épaisse (102).

10. Procédé de fabrication du transistor de type MOS selon la revendication 1, ce procédé étant **caractérisé en ce qu'**il comprend les étapes suivantes :
- on forme une structure comprenant le substrat (50), la zone active et, de part et d'autre de celle-ci, deux zones d'isolation de champ (60, 62), et la zone de grille (71), la zone active étant la zone où seront formés la source, le drain et la région du canal située sous la grille,
- on forme deux évidements (110, 112) dans le substrat, l'un entre l'une des zones d'isolation de champ et la zone de grille et l'autre entre cette zone de grille et l'autre zone d'isolation de champ, les flancs respectifs des évidements les plus proches de la zone de grille étant situés sous celle-ci,
- on forme, sur lesdits flancs, lesdites couches électriquement isolantes suffisamment minces (88, 90) qui séparent les zones de source et de drain du canal et qui sont suffisamment minces pour permettre le passage de porteurs de charges, par effet tunnel, de la zone de source à la zone de drain à travers le canal et l'on forme lesdites couches isolantes d'épaisseur suffisamment forte pour empêcher tout passage de porteurs de charges à travers cette couche isolante (84, 86) au fond des évidements, et
- on forme les zones de source et de drain (92, 94) respectivement dans les évidements.

11. Procédé selon la revendication 10 pour la fabrication du transistor selon la revendication 8, **caractérisé en ce que** lesdites couches isolantes suffisamment minces sont d'abord formées et lesdites couches de silice (84, 86) sont ensuite formées en dopant des zones du substrat au fond des évidements, par des impuretés permettant une oxydation rapide du substrat, puis en oxydant les zones ainsi dopées.

12. Procédé selon la revendication 11, **caractérisé en ce que** les couches isolantes suffisamment minces sont en silice ou en nitrure de silicium.

13. Procédé selon la revendication 10 pour la fabrication du transistor selon la revendication 8, **caractérisé en ce que**, pour former les dites couches isolantes suffisamment minces et lesdites couches de silice (84, 86), on dépose du nitrure de silicium dans les évidements, on élimine le nitrure ainsi déposé, l'élimination n'ayant pas lieu sur les flancs de manière à former lesdites couches isolantes suffisamment minces, et on oxyde des zones du substrat au fond des évidements de manière à former lesdites couches de silice.

14. Procédé selon la revendication 10 pour la fabrication du transistor selon la revendication 8, **caractérisé en ce que**, pour former lesdites couches isolantes suffisamment minces et lesdites couches de silice (84, 86), on dépose du nitrure de silicium dans les évidements, on élimine le nitrure ainsi déposé, l'élimination n'ayant pas lieu sur lesdits flancs, on oxyde des zones du substrat au fond des évidements de manière à former lesdites couches de silice, on élimine le nitrure desdits flancs et on oxyde ces flancs de manière à former lesdites couches isolantes suffisamment minces.

15. Procédé de fabrication du transistor de type MOS selon la revendication 9, ce procédé étant **caractérisé en ce qu'**il comprend les étapes suivantes :
- on forme une structure comprenant le substrat (100), la couche isolante très épaisse (102) empêchant tout passage de porteurs de charges à travers cette couche isolante, une couche de semiconducteur (104) au dessus de celle-ci, la zone active et, de part et d'autre de celle-ci, deux zones d'isolation de champ (60, 62), et la zone de grille (71), la zone active étant la zone où seront formés la source, le drain et la région du canal située sous la grille,
- on forme deux évidements (110, 112) dans ladite couche de semiconducteur, l'un entre l'une des zones d'isolation de champ et la zone de grille et l'autre entre cette zone de grille et l'autre zone d'isolation de champ, les flancs respectifs des évidements les plus proches de la zone de grille étant situés sous celle-ci,
- on forme, sur lesdits flancs, lesdites couches suffisamment minces électriquement isolantes (116, 118) qui séparent les zones de source et de drain du canal et qui sont suffisamment minces pour permettre le passage de porteurs de charges, par effet tunnel, de la zone de source à la zone de drain à travers le canal, et
- on forme les zones de source et de drain (92, 94) respectivement dans les évidements.

16. Procédé selon la revendication 15 pour la fabrication du transistor selon la revendication 5, la couche très épaisse étant en silice, **caractérisé en ce que** lesdites couches isolantes suffisamment minces sont en silice ou en nitrure de silicium.

17. Procédé selon la revendication 15 pour la fabrication du transistor selon la revendication 5,
la couche très épaisse étant en silice, **caractérisé en ce que**, pour former lesdites couches isolantes suffisamment minces (116, 118), on dépose du nitrure de silicium dans les évidements et on élimine le nitrure ainsi déposé, l'élimination n'ayant pas lieu sur lesdits flancs.

18. Application du transistor de type MOS selon la revendication 3 aux mémoires non volatiles, le canal de ce transistor étant un volume fermé.

## Claims

1. MOS type transistor comprising:
- a semiconductor substrate (50; 100),
- a grid area (71),
- a semiconductor channel (95; 114; 138) located under the grid area and electrically insulated from it, and
- a source area and a drain area (92, 94) that are located on each side of the grid area and the channel and which are electrically insulated from the substrate and the grid area,
the source and drain areas being separated from the channel by electrically insulating layers (88, 90; 116, 118; 124, 126; 142, 144) respectively that are sufficiently thin to enable charge carriers to pass by means of the tunnel effect from the source area to the drain area through the channel, said transistor being **characterized in that** each of the source and drain areas is separated from the substrate by an electrically insulating layer sufficiently thick to prevent any passage of charge carriers through this insulating layer.

2. MOS type transistor according to claim 1, **characterized in that** each of the source and drain areas (92, 94) is made of a metallic material.

3. MOS type transistor according to either of claims 1 and 2, **characterized in that** the channel is electrically insulated from the substrate (50; 100).

4. MOS type transistor according to either of claims 1 and 2, **characterized in that** the channel is in electrical contact with the substrate (50; 100) through a narrow area of this substrate, said area being smaller than the channel.

5. MOS type transistor according to any one of claims 1 to 4, **characterized in that** the substrate (50; 100) and the channel (95; 114; 138) are made of silicon.

6. MOS type transistor according to claim 5, **characterized in that** the sufficiently thin insulating layers are made of silica.

7. MOS type transistor according to claim 5, **characterized in that** the sufficiently thin insulating layers are made of silicon nitride.

8. MOS type transistor according to any one of claims 5 to 7, **characterized in that** the insulating layer that separates each of the source and drain areas (92, 94) of the substrate is a silica layer (84; 86; 132, 134).

9. MOS type transistor according to any one of claims 1 to 7, **characterized in that** the source area, the drain area and the channel are separated from the substrate by a very thick electrically insulating layer (102).

10. Process for manufacturing the MOS type transistor according to claim 1, this process being **characterized in that** it comprises the following steps:
- a structure is formed comprising the substrate (50), the active area and two field insulation areas (60, 62) on each side of the active area, and the grid area (71), the active area being that where the source, drain and region of the channel located beneath the grid will be formed,
- two recesses (110, 112) are formed in the substrate, one between one of the field insulation areas and the grid area, and the other between this grid area and the other field insulation area, the flanks of the recesses closest to the grid area being located under the grid area,
- on said flanks are formed the sufficiently thin electrically insulating layers (88, 90), which separate the source and drain areas of the channel and which are sufficiently thin to permit the passage of charge carriers by a tunnel effect from the source area to the drain area through the channel and formation takes place of said sufficiently thick insulating layers (84, 86) at the bottom of the recesses in order to prevent any passage of charge carriers through said insulating layer and
- the source and drain areas (92, 94 respectively) are formed in the recess.

11. Process according to claim 10 for manufacturing the transistor according to claim 8, **characterized in that** the said sufficiently thin insulating areas are formed first and the said silica layers (84, 86) are then formed by doping substrate areas at the bottom of recesses by impurities enabling fast oxidation of the substrate and then oxidizing the areas thus doped.

12. Process according to claim 11, **characterized in that** the sufficiently thin insulating layers are made of silica or silicon nitride.

13. Process according to claim 10 for manufacturing the transistor according to claim 8, **characterized in that** the said sufficiently thin insulating layers and the said silica layers (84, 86) are formed by depositing silicon nitride in the recesses, the nitride thus deposited is eliminated except on the flanks so as to form the said sufficiently thin insulating layers, and the substrate areas at the bottom of the recesses are oxidized so as to form the said silica layers.

14. Process according to claim 10 for manufacturing the transistor according to claim 8, **characterized in that** the said sufficiently thin insulating layers and the said silica layers (84, 86) are formed by depositing silicon nitride in the recesses, eliminating the nitride thus deposited except on the said flanks, the substrate areas at the bottom of the recesses are oxidized so as to form the said silica layers, the nitride from the said flanks is eliminated and these flanks are oxidized so as to form the said sufficiently thin insulating layers.

15. Process for manufacturing the MOS type transistor according to claim 9, this process being **characterized in that** it comprises the following steps:
- a structure is formed comprising the substrate (100), the very thick insulating layer (102) preventing any passage of charge carriers through said insulating layer, a semiconductor layer (104) above this layer, the active area and two field insulation areas (60, 62) on each side of the active area, and the grid area (71), the active area being that where the source, drain and region of the channel located beneath the grid will be formed,
- two recesses (110, 112) are formed in the said semiconductor layer, one between one of the field insulation areas and the grid area, and the other between this grid area and the other field insulation area, the flanks of the recesses closest to the grid area being located under the grid area,
- said sufficiently thin, electrically insulating layers (116, 118) are formed on said flanks and separate the source and drain areas of the channel and are sufficiently thin to permit the passage of charge carriers, by a tunnel effect, from the source area to the drain area through the channel,
- the source and the drain areas (92, 94 respectively) are formed in the recesses.

16. Process according to claim 15 for manufacturing the transistor according to claim 5, the very thick layer being made of silica, **characterized in that** the said sufficiently thin insulation layers are made of silica or silicon nitride.

17. Process according to claim 15 for manufacturing the transistor according to claim 5, the very thick layer being made of silica, **characterized in that** the said sufficiently thin insulation layers (116, 118) are formed by depositing silicon nitride in the recesses, and the nitride thus deposited is eliminated except on the said flanks.

18. Application of the MOS type transistor according to claim 3 to nonvolatile memories, the channel of this transistor being a closed volume.

## Patentansprüche

1. Transistor des MOS-Typs, umfassend:
- ein Halbleitersubstrat (50 ; 100),
- eine Gate-Zone (71),
- einen Halbleiterkanal (95 ; 114 ; 138), unter der Gate-Zone befindlich und von dieser elektrisch isoliert, und
- eine Source-Zone und eine Drain-Zone (92, 94), die sich beiderseits der Gate-Zone und des Kanals befinden und elektrisch vom Substrat und der Gate-Zone isoliert sind,
wobei die Source- und Drain-Zonen vom Kanal jeweils durch elektrisch isolierende Zonen (88, 90; 116, 118; 124, 126; 142, 144) getrennt sind, die ausreichend dünn sind, um den Durchgang von Ladungsträgern von der Source-Zone zur Drain-Zone durch den Kanal hindurch mittels Tunneleffekt zu ermöglichen,
**dadurch gekennzeichnet,**
**dass** jede der Zonen von Source und Drain vom Substrat durch eine elektrisch isolierende Schicht getrennt ist, deren Dicke ausreichend groß ist, um jeden Durchgang von Ladungsträgern durch diese isolierende Schicht hindurch zu verhindern.

2. Transistor des MOS-Typs nach Anspruch 1, **dadurch gekennzeichnet, dass** jede der Source- und Drain-Zonen (92, 94) aus einem metallischen Material ist.

3. Transistor des MOS-Typs nach einem der Ansprüche 1 und 2, **dadurch gekennzeichnet, dass** der Kanal vom Substrat (50; 100) elektrisch isoliert ist.

4. Transistor des MOS-Typs nach einem der Ansprüche 1 und 2, **dadurch gekennzeichnet, dass** der Kanal mit dem Substrat (50; 100) elektrischen Kontakt hat mittels einer schmalen Zone dieses Substrats, wobei diese Zone kleiner als der Kanal ist.

5. Transistor des MOS-Typs nach einem der Ansprüche 1 bis 4, **dadurch gekennzeichnet, dass** das Substrat (50; 100) und der Kanal (95; 114; 138) aus Silicium sind.

6. Transistor des MOS-Typs nach Anspruch 5, **dadurch gekennzeichnet, dass** die ausreichend dünnen isolierenden Schichten aus Siliciumdioxid sind.

7. Transistor des MOS-Typs nach Anspruch 5, **dadurch gekennzeichnet, dass** die ausreichend dünnen isolierenden Schichten aus Siliciumnitrid sind.

8. Transistor des MOS-Typs nach einem der Ansprüche 5 bis 7, **dadurch gekennzeichnet, dass** die isolierende Schicht, die jede der Source- und Drain-Zonen (92, 94) vom Substrat trennt, eine Siliciumdioxidschicht (84; 86; 132, 134) ist.

9. Transistor des MOS-Typs nach einem der Ansprüche 1 bis 7, **dadurch gekennzeichnet, dass** die Source-Zone, die Drain-Zone und der Kanal vom Substrat durch eine sehr dicke, elektrisch isolierende Schicht (102) getrennt sind.

10. Verfahren zur Herstellung des MOS-Transistors nach Anspruch 1, wobei dieses Verfahren **dadurch gekennzeichnet ist, dass** es die folgenden Schritte umfasst:
- man bildet eine das Substrat (50), die aktive Zone und - beiderseits von dieser - zwei Feldisolationszonen (60, 62) und die Gate-Zone (71) umfassende Struktur, wobei die aktive Zone die Zone umfasst, in der die Source, der Drain und die unter dem Gate befindliche Kanalregion ausgebildet sind,
- man bildet in dem Substrat zwei Aussparungen (110, 112), die eine zwischen einer der Feldisolationszonen und der Gate-Zone und die andere zwischen dieser Gate-Zone und der anderen Feldisolationszone, wobei die jeweiligen Flanken der Aussparungen, die am nächsten bei der Gate-Zone sind, sich unter dieser befinden,
- man bildet auf den genannten Flanken ausreichend dünne elektrisch isolierende Schichten (88, 90), die die Source- und Drain-Zonen vom Kanal trennen und so dünn sind, dass sie den Durchgang von Ladungsträgern von der Source-Zone zur Drain-Zone durch den Kanal hindurch mittels Tunneleffekt ermöglichen, und man bildet auf dem Boden der Aussparungen die genannten isolierenden Schichten (84, 86), deren Dicke ausreichend groß ist, um jeden Durchgang von Ladungsträgern durch diese isolierende Schicht zu verhindern, und
- man bildet die Source- und Drain-Zonen (92, 94) jeweils in diesen Aussparungen.

11. Verfahren nach Anspruch 10 zur Herstellung des Transistors nach Anspruch 8, **dadurch gekennzeichnet, dass** zuerst die genannten ausreichend dünnen isolierenden Schichten ausgebildet werden und anschließend die genannten Siliciumdioxid-Schichten (84, 86) gebildet werden, indem Zonen des Substrats am Boden der Aussparungen durch Verunreinigungen dotiert werden, die eine schnelle Oxidation des Substrats ermöglichen, sodann indem man die derart dotierten Zonen oxidiert.

12. Verfahren nach Anspruch 11, **dadurch gekennzeichnet, dass** die ausreichend dünnen isolierenden Schichten aus Siliciumdioxid oder aus Siliciumnitrid sind.

13. Verfahren nach Anspruch 10 zur Herstellung des Transistors nach Anspruch 8. **dadurch gekennzeichnet, dass** man zur Bildung der genannten ausreichend dünnen isolierenden Schichten und der genannten Siliciumdioxid-Schichten (84, 86) in den Aussparungen Siliciumnitrid abscheidet, man das abgeschiedene Siliciumnitrid beseitigt, wobei die Beseitigung auf den Flanken nicht stattfindet, um die genannten ausreichend dünnen isolierenden Schichten zu bilden, und man Zonen des Substrats auf dem Boden der Aussparungen oxidiert, um die genannten Siliciumdioxid-Schichten zu bilden.

14. Verfahren nach Anspruch 10 zur Herstellung des Transistors nach Anspruch 8, **dadurch gekennzeichnet, dass** man zur Bildung der genannten ausreichend dünnen isolierenden Schichten und der genannten Siliciumdioxid-Schichten (84, 86) in den Aussparungen Siliciumnitrid abscheidet, man das abgeschiedene Siliciumnitrid beseitigt, wobei die Beseitigung auf den genannten Flanken nicht stattfindet, man Zonen des Substrats auf dem Boden der Aussparungen oxidiert, man das Nitrid auf den genannten Flanken beseitigt und man diese Flanken oxidiert, um die genannten ausreichend dünnen Siliciumdioxid-Schichten zu bilden.

15. Verfahren zur Herstellung des MOS-Transistors nach Anspruch 9, **dadurch gekennzeichnet**, wobei dieses Verfahren **dadurch gekennzeichnet ist, dass** es die folgenden Schritte umfasst:
- man bildet eine Struktur, die eine das Substrat (100), die sehr dicke, jeden Durchgang von Ladungsträgern verhindernde Isolierschicht (102), auf dieser eine Halbleiterschicht (104), die aktive Zone und - beiderseits von dieser - zwei Feldisolationszonen (60, 62) und die Gate-Zone (71) umfasst, wobei die aktive Zone die Zone umfasst, in der die Source, der Drain und die unter dem Gate befindliche Kanalregion ausgebildet sind,
- man bildet in der genannten Halbleiterschicht zwei Aussparungen (110, 112), die eine zwischen einer der Feldisolationszonen und der Gate-Zone und die andere zwischen dieser Gate-Zone und der anderen Feldisolationszone, wobei die jeweiligen Flanken der Aussparungen, die am nächsten bei der Gate-Zone sind, sich unter dieser befinden,
- man bildet auf den genannten Flanken ausreichend dünne elektrisch isolierende Schichten (116, 118), die die Source- und Drain-Zonen vom Kanal trennen und so dünn sind, dass sie den Durchgang von Ladungsträgern von der Source-Zone zur Drain-Zone durch den Kanal hindurch mittels Tunneleffekt ermöglichen, und
- man bildet die Source- und Drain-Zonen (92, 94) jeweils in diesen Aussparungen.

16. Verfahren nach Anspruch 15 zur Herstellung des Transistors nach Anspruch 5, wobei die sehr dicke Schicht aus Siliciumdioxid ist, **dadurch gekennzeichnet, dass** die genannten ausreichend dünnen isolierenden Schichten aus Siliciumdioxid oder aus Siliciumnitrid sind.

17. Verfahren nach Anspruch 15 zur Herstellung des Transistors nach Anspruch 5, wobei die sehr dicke Schicht aus Siliciumdioxid ist, **dadurch gekennzeichnet, dass** man, um die genannten ausreichend dünnen isolierenden Schichten (116, 118) zu bilden, in den Aussparungen Siliciumnitrid abscheidet und das so abgeschiedene Nitrid beseitigt, wobei die Beseitigung auf den genannten Flanken nicht stattfindet.

18. Anwendung des MOS-Transistors nach Anspruch 3 in den permanenten bzw. energieunabhängigen Speichern, wobei der Kanal des Transistors ein geschlossenes Volumen ist.
